(19) Europäisches Patentamt
European Patent Office
Office européen des brevets

(11) **EP 4 206 139 A1**

(12) **EUROPEAN PATENT APPLICATION**
published in accordance with Art. 153(4) EPC

(43) Date of publication:
**05.07.2023 Bulletin 2023/27**

(21) Application number: **21861454.3**

(22) Date of filing: **20.08.2021**

(51) International Patent Classification (IPC):
$C01G\ 41/00^{(2006.01)}$   $C09K\ 3/00^{(2006.01)}$
$C23C\ 14/08^{(2006.01)}$   $C23C\ 14/34^{(2006.01)}$

(52) Cooperative Patent Classification (CPC):
**C01G 41/00; C09K 3/00; C23C 14/08; C23C 14/34**

(86) International application number:
**PCT/JP2021/030695**

(87) International publication number:
**WO 2022/045028 (03.03.2022 Gazette 2022/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.08.2020 JP 2020143002**

(71) Applicant: **SUMITOMO METAL MINING CO., LTD.
Tokyo
105-8716 (JP)**

(72) Inventors:
• **ADACHI, Kenji**
**Ichikawa-shi, Chiba 272-8588 (JP)**
• **SATO, Keiichi**
**Isa-shi, Kagoshima 895-2501 (JP)**
• **YOSHIO, Satoshi**
**Niihama-shi, Ehime 792-0001 (JP)**

(74) Representative: **Jones, Nicholas Andrew
Withers & Rogers LLP
2 London Bridge
London SE1 9RA (GB)**

(54) **NEAR-INFRARED SHIELDING FILM, METHOD FOR PRODUCING NEAR-INFRARED SHIELDING FILM**

(57) A near-infrared shielding film including a continuous film of a cesium tungsten composite oxide represented by a general formula $Cs_xW_yO_z$, where $4.8 \leq x \leq 14.6$, $20.0 \leq y \leq 26.7$, $62.2 \leq z \leq 71.4$, and $x + y + z = 100$, is provided. The continuous film includes one or more crystals selected from an orthorhombic crystal, a rhombohedral crystal, and a hexagonal crystal.

## Description

[Technical Field]

The present invention relates to a near-infrared shielding film and a method for producing a near-infrared shielding film.

[Background Art]

With the number of record-breaking hot years increasing, environmental measures against heat have become a matter of great concern worldwide. Solar radiation shielding films are required as one of the environmental measures to shield near-infrared light of components of sunlight to prevent unwanted heat from entering the room. In particular, in automotive window components, solar radiation shielding films are becoming increasingly important for heat management due to the shift to electric vehicles.

In addition, with the shift to the 5th generation mobile communication system (5G), which is the next generation communication system, the shift to automated driving is accelerating. There is a demand for windows that do not interfere with various communication radio waves, such as GPS information, electromagnetic waves in the MHz to GHz band of smartphones, and near-infrared signals for controlling headlights and wipers.

Various materials have been proposed as light shielding materials used for window materials and the like. For example, PTL 1 discloses a heat insulating sheet formed of a knit fabric using a strip-shaped film having infrared reflectivity and a strip-shaped film having infrared absorptivity as warp yarns and weft yarns, respectively. It is also disclosed that the strip-shaped film having infrared reflectivity is a synthetic resin film subjected to an aluminum vapor deposition process. However, when this type of light shielding material is used, the appearance is half-mirror-like, and thus the reflections are too bright for outdoor use, which poses a problem in terms of the view.

PTL 2 discloses an infrared-shielding material fine particle dispersion in which tungsten oxide particles or composite tungsten oxide particles are dispersed in a solid medium such as a resin, and also discloses that an infrared-shielding effect can be imparted to window materials and the like.

A dispersion of composite tungsten oxide particles and the like is known as a material that exhibits excellent optical characteristics, such as efficiently shielding sunlight, especially light in the near-infrared region, and maintaining high transmittance in the visible light region. PTL 2 also proposes, as a method for producing an infrared-shielding material fine particle dispersion, to disperse infrared-shielding material particles such as composite tungsten oxide particles in an appropriate solvent to form a dispersion liquid, add a medium resin to the obtained dispersion liquid, and then coat the surface of the substrate with it.

Meanwhile, tin oxide and indium tin oxide (ITO), which are transparent conductors, are also known as solar radiation shielding materials. PTL 3 discloses a method for producing a substrate with a heat ray shielding film, in which a heat ray shielding film containing a conductive oxide is formed on the substrate by sputtering or the like, and a protective film containing a silicon oxide and an alkali metal oxide is formed on the heat ray shielding film. As the conductive oxide, tin-containing indium oxide is mentioned.

Because the plasma frequency of tin oxide and ITO is in the near-infrared light region, there is an advantage of ensuring transparency over a wide range of visible light region, and infrared light with a longer wavelength than the plasma wavelength can be excluded by plasma reflection. Another advantage is that, with the exception of a protective film to ensure weather resistance, a single-layer film is basically all that is required to perform the function. However, the density of free electrons contained in the transparent conductive material such as tin oxide is lower than that of metals, and the plasma wavelength is slightly longer. Therefore, near-infrared light with the shortest wavelength, which is strong light in sunlight, is not shielded. Accordingly, in spite of being a film with a reflecting function of heat rays, the solar radiation shielding function is at a level equal to or lower than that of a high-performance nanoparticle dispersion film.

In addition, thin films of metals such as Ag (silver) or Au (gold) strongly reflect infrared light, but shield visible light depending on the wavelength of the visible light because the plasma frequency overlaps the visible light region. The metal thin films are strongly colored and become a dark film. Thus, a multilayer film is used in which the metal thin films and colorless dielectric thin films with a high refractive index are alternately laminated, thereby shifting the effective rise wavelength of the near-infrared reflection from the visible light region to the near-infrared light region by the light interference. Among them, a multilayer thin film composed of Ag and a dielectric can achieve the highest performance solar radiation shielding film because it has no coloration, high visible light transmittance, and blocks near-infrared light to a high degree. PTL 4 discloses a technique of heat ray shielding glass in which a dielectric layer and a metal layer containing silver as a main component are laminated.

[Citation List]

[Patent Literature]

[PTL 1] Japanese Laid-Open Patent Publication No. H9-107815
[PTL 2] WO 2005/37932
[PTL 3] Japanese Laid-Open Patent Publication No.

2004-338985

[PTL 4] Japanese Laid-Open Patent Publication No. 2006-117482

[NPL 1] S. F. Solodovnikov, N.V. Ivannikova, Z.A. Solodovnikova, E.S. Zolotova, "Synthesis and X-ray diffraction study of potassium, rubidium, and cesium polytungstates with defect pyrochlore and hexagonal tungsten bronze structures", Inorganic Materials, Vol. 34, pp. 845-853, 1998

[Summary of Invention]

[Technical Problem]

However, the transparent conductor thin film and the multilayer film of metals and dielectrics described above also have high conductivity. For this reason, there is a problem of reflecting and interfering with communication radio waves and broadcasting radio waves having frequencies in the MHz to GHz band. In order to prevent such communication interference, for example, a notch is made in part of the radio wave reflector to enable communication. However, the radio wave reflectivity is based on the plasma reflection of free electrons in the near-infrared shielding material. Therefore, there has been a demand for a near-infrared shielding film based on a different principle from the transparent conductor thin film and the multilayer film of metals and dielectrics, and the like.

As described above, when a highly conductive film is used as a near-infrared shielding film, there is a problem that electromagnetic waves for various communications are reflected. However, when a film that transmits electromagnetic waves is used, the heat ray shielding function is insufficient.

An object of one aspect of the present invention is to provide a near-infrared shielding film having high heat ray shielding performance and excellent transparency of visible light and electromagnetic waves.

[Solution to Problem]

One aspect of the present invention provides: a near-infrared shielding film including a continuous film of a cesium tungsten composite oxide represented by a general formula $Cs_xW_yO_z$, where $4.8 \leq x \leq 14.6$, $20.0 \leq y \leq 26.7$, $62.2 \leq z \leq 71.4$, and $x + y + z = 100$, wherein the continuous film includes one or more crystals selected from an orthorhombic crystal, a rhombohedral crystal, and a hexagonal crystal.

[Advantageous Effects of Invention]

According to one aspect of the present invention, a near-infrared shielding film having high heat ray shielding performance and excellent transparency of visible and electromagnetic waves can be provided.

[Brief Description of the Drawings]

[FIG. 1]
FIG. 1 is a flow diagram of a method for producing a near-infrared shielding film according to an embodiment of the present invention;
[FIG. 2]
FIG. 2 is an XRD pattern of the near-infrared shielding film obtained in Example 1;
[FIG. 3A]
FIG. 3A is spectral characteristics of the near-infrared shielding film obtained in Example 1;
[FIG. 3B]
FIG. 3B is spectral characteristics of the near-infrared shielding film obtained in Example 1;
[FIG. 4]
FIG. 4 is a STEM-HAADF image of the near-infrared shielding film obtained in Example 1;
[FIG. 5]
FIG. 5 is an XRD pattern of the near-infrared shielding film obtained in Example 2;
[FIG. 6A]
FIG. 6A is spectral characteristics of the near-infrared shielding film obtained in Example 2;
[FIG. 6B]
FIG. 6B is spectral characteristics of the near-infrared shielding film obtained in Example 2;
[FIG. 7]
FIG. 7 is a STEM-HAADF image of the near-infrared shielding film obtained in Example 2;
[FIG. 8]
FIG. 8 is an XRD pattern of the near-infrared shielding film obtained in Example 3;
[FIG. 9A]
FIG. 9A is spectral characteristics of the near-infrared shielding film obtained in Example 3;
[FIG. 9B]
FIG. 9B is spectral characteristics of the near-infrared shielding film obtained in Example 3;
[FIG. 10]
FIG. 10 is an XRD pattern of the near-infrared shielding film obtained in Example 4;
[FIG. 11A]
FIG. 11A is spectral characteristics of the near-infrared shielding film obtained in Example 4;
[FIG. 11B]
FIG. 11B is spectral characteristics of the near-infrared shielding film obtained in Example 4;
[FIG. 12]
FIG. 12 is a $\eta$-VLT graph of the near-infrared shielding films obtained in Examples 1 to 4;
[FIG. 13A]
FIG. 13A is XPS-W4f spectra of the near-infrared shielding films of Examples 1 to 3, Reference Sample 1, and Reference Sample 2, and the cesium tungsten composite oxide powder;

[FIG. 13B]
FIG. 13B is results of XPS-W4f spectra of the near-infrared shielding films of Examples 1 to 3, Reference Sample 1, and Reference Sample 2, and the cesium tungsten composite oxide powder;
[FIG. 14A]
FIG. 14A is XPS-O1s spectra of the near-infrared shielding films of Examples 1 to 3, Reference Sample 1, and Reference Sample 2, and the cesium tungsten composite oxide powder;
[FIG. 14B]
FIG. 14B is results of XPS-O1s spectra of the near-infrared shielding films of Examples 1 to 3, Reference Sample 1, and Reference Sample 2, and the cesium tungsten composite oxide powder;
[FIG. 15A]
FIG. 15A is results of XPS observations of the valence band and the lower part of the conduction band of the near-infrared shielding film of Example 1;
[FIG. 15B]
FIG. 15B is results of XPS observations of the valence band and the lower part of the conduction band of the near-infrared shielding film of Example 2;
[FIG. 15C]
FIG. 15C is results of XPS observations of the valence band and the lower part of the conduction band of the near-infrared shielding film of Example 1; and
[FIG. 15D]
FIG. 15D is results of XPS observations of the valence band and the lower part of the conduction band of the near-infrared shielding film of Example 2.

[Description of Embodiments]

[Near-Infrared Shielding Film]

The near-infrared shielding film of the present embodiment is composed of a continuous film of a cesium tungsten composite oxide represented by a general formula $Cs_xW_yO_z$ ($4.8 \leq x \leq 14.6$, $20.0 \leq y \leq 26.7$, $62.2 \leq z \leq 71.4$, and $x + y + z = 100$). The continuous film includes one or more crystals selected from an orthorhombic crystal, a rhombohedral crystal, and a hexagonal crystal.

In conventional near-infrared shielding films, the basic principle of near-infrared shielding is plasma reflection by free electrons in the material.

In contrast, the basic principle of near-infrared shielding in the near-infrared shielding film of the present embodiment is interband transition of bound electrons. The bound electrons are electrons in a state in which excess electrons generated in a cation due to the formation of oxygen deficiency and other factors, are bound to lattice points while locally distorting the ionic crystal lattice. The mode of movement in a solid in response to external voltage (potential) is different for bound electrons and free electrons. The bound electrons move slower in a solid due to an external voltage than free electrons. Therefore, when the lattice distortion or electron binding is strong, the conductivity of the thin film is greatly reduced.

As for the response to electromagnetic waves in the visible light region and the near-infrared light region, in the case of free electrons, energy below the plasma frequency is plasma-reflected. In contrast, bound electrons absorb electromagnetic waves in the vicinity of the excitation energy and undergo an electron transition (interband transition). Thus, the optical response in the vicinity of the plasma wavelength of a thin film with bound electrons is absorption rather than reflection. Furthermore, when the band gap is around 3eV and the interband transition between the hybrid orbitals formed by the d orbital of the metal and the p orbital of the ligand (oxygen) is suppressed by the Fermi golden rule, as in the metal oxides of the present invention, large visible light transparency can be expected.

Thus, there have been few reports of thin film materials that absorb infrared light, are transparent to visible light, and transmit electromagnetic waves in the MHz and GHz bands due to their low conductivity. However, it is conceivable that there is actually a large number of them.

Hereinafter, a cesium tungsten composite oxide, or a cesium polytungstate material, which is one of the materials having the above characteristics, will be described in detail.

The near-infrared shielding film according to the present embodiment is composed of a continuous film of a cesium tungsten composite oxide, as described above. The continuous film of the cesium tungsten composite oxide is referred to as a cesium polytungstate film, and is hereinafter described as a CPT film. The cesium tungsten composite oxide may be described as CPT.

(1) Composition

The CPT film constituting the near-infrared shielding film according to the present embodiment contains cesium (Cs), tungsten (W), and oxygen (O) as main components, and includes crystals having one or more crystal structures selected from an orthorhombic crystal, a rhombohedral crystal, and a hexagonal crystal.

The presence of crystal structures of hexagonal, orthorhombic, and rhombohedral crystals can be determined by X-ray diffraction measurement of the film. The CPT is known to have a crystal structure such as hexagonal, cubic, tetragonal, orthorhombic, and rhombohedral, as well as an amorphous structure. The CPT film that constitutes the near-infrared shielding film according to the present embodiment has a hexagonal, orthorhombic, or rhombohedral crystal structure. However, the CPT film may include crystal structures other than the hexagonal, orthorhombic, and rhombohedral crystal structure, such as a cubic or tetragonal crystal structure, and the amorphous structure.

The CPT constituting the CPT film is represented by the general formula $Cs_xW_yO_z$. In the above general formula, x, y, z is $4.8 \leq x \leq 14.6$, $20.0 \leq y \leq 26.7$, $62.2 \leq z \leq 71.4$, and $x + y + z = 100$.

Cs is an element required to maintain a hexagonal, orthorhombic, or rhombohedral crystal lattice. By setting the content of Cs to 4.8 atom% or more, phase separation of crystals can be prevented. In addition, by setting the content of Cs to 14.6 atom% or less, excellent spectral characteristics can be obtained.

W is a basic element that allows the CPT film to exhibit excellent spectral characteristics. By setting the content of W to 20.0 atom% or more, absorption of light in the near-infrared light region can be increased. In addition, by setting the content of W to 26.7 atom% or less, the transmittance of light in the visible light region can be increased.

O is an element that affects the optical absorption characteristics of the CPT film in balance with the content of W. By setting z, which indicates the content of O, within the above range, phase separation of crystals can be prevented, and a film having suitable near-infrared absorption characteristics can be obtained.

The CPT film of the near-infrared shielding film according to the present embodiment may be composed of a continuous film, specifically, a continuous thin film of polycrystalline material. The CPT film may contain voids.

(2) Crystal Structure

The crystal structure of the CPT constituting the CPT film of the near-infrared shielding film according to the present embodiment is preferably a hexagonal crystal in which a basic unit is a $WO_6$ octahedron (W-O octahedron) formed of tungsten (W) and oxygen (O), and the basic units are arranged in hexagonal symmetry. The crystal structure of the CPT is not limited to this form and may be what is known as an orthorhombic crystal or a rhombohedral crystal due to lattice defects contained therein. That is, the continuous film included in the near-infrared shielding film according to the present embodiment may include one or more crystals selected from the orthorhombic crystal, the rhombohedral crystal, and the hexagonal crystal. The continuous film included in the near-infrared shielding film according to the present embodiment may be composed of one or more crystals selected from the orthorhombic crystal, the rhombohedral crystal, and the hexagonal crystal.

The orthorhombic CPT and the hexagonal CPT are linked by a lattice correspondence of (001)H//(001)R, (110)H//(100)R, and (-110)H//(010)R (where H and R represent a hexagonal crystal and an orthorhombic crystal, respectively; the same applies below). The c-axis of the orthorhombic crystal is equal to the c-axis of the hexagonal crystal.

In the near-infrared shielding film according to the present embodiment, a planar or linear lattice defect may be included in at least part of the (010)R plane of the orthorhombic crystal, or one or more planes selected from the prism plane [(100)H, (010)H, (110)H] and the basal plane (001)H of the hexagonal crystal.

As described above, when the planar or linear lattice defect is included in at least part of the one or more planes selected from the prism plane [(100)H, (010)H, (110)H] and the basal plane (001)H of the hexagonal crystal, the axial lengths of the a- and b- axes of the hexagonal crystal differ depending on the amount of the lattice defect because the interatomic distance changes in the lattice defect. Consequently, it is no longer hexagonally symmetric and becomes an orthorhombic crystal.

The lattice defect is often included at the basal plane (001)H of the hexagonal crystal when the Cs/W ratio of the entire crystal is greater than 0.33. In this case, excess Cs is captured in the three-sided void on the bottom, and the stacking order of the bottom is modified from hexagonal ABAB stacking to, for example, $ABC\Delta ABC\Delta$ stacking (where $\Delta$ is the Cs insertion plane) including the pyrochlore type stacking (fine stacking structure of cubic (111) plane). In such a case where only the basal plane (001)H is modified without modifying the prism plane, the trigonal symmetry with the c-axis as the axis of symmetry is retained, but the length of the c-axis changes, resulting in a rhombohedral crystal. Therefore, the crystal structure of the CPT film is basically a hexagonal crystal in which W-O octahedrons are arranged in hexagonal symmetry. However, when even a small amount of lattice defects are present on the prism plane or basal plane, it should be correctly described as an orthorhombic crystal or a rhombohedral crystal.

The near-infrared shielding film according to the present embodiment may include one or more types selected from a tungsten deficiency and a cesium deficiency as the lattice defect. The CPT film may include the tungsten deficiency as the most major defect.

When the CPT film, which is the near-infrared shielding film according to the present embodiment, is crystallized in the atmosphere or in a low-reducing atmosphere and then annealed by heating for a sufficient time to approach the equilibrium phase, the structure is such that tungsten deficiencies are arranged on one prism plane at regular intervals. An example of such a tungsten deficiency is the $Cs_4W_{11}O_{35}$ phase. In the $Cs_4W_{11}O_{35}$ phase, the tungsten-deficient plane of the (010)R plane is arranged at a frequency of 8:1 in the b-axis direction of the orthorhombic crystal. However, the CPT film of the present invention is not limited to such a form, and the manner of the tungsten deficiency differs depending on the Cs/W composition and the content of O. For example, in one form, the tungsten deficiency may be present across the three prism planes.

In order to represent the tungsten deficiency, when the CPT is represented by a general formula $Cs_\alpha W_{1-\beta}O_{3-\gamma}$, the composition range of each of these components is $0.2 \leq \alpha \leq 0.54$, $0 \leq \beta \leq 0.115$, and $0 \leq \gamma \leq 0.46$. In the formula, the maximum value of $\beta$ indicating the tungsten deficiency is 0.115. Cs is the cation required for the hexagonal configuration of the $WO_6$ octahedron,

and $\alpha$ may be $0.2 \leq \alpha \leq 0.54$, as described above.

In the crystal structure of the orthorhombic, rhombohedral, or hexagonal crystal of the CPT, the basic unit is the $WO_6$ octahedron formed of tungsten (W) and oxygen (O), as described above. However, a portion of the O of the $WO_6$ octahedron may be further randomly deficient by reduction. That is, a portion of the O of the $WO_6$ octahedron constituting the one or more crystals selected from the orthorhombic crystal, the rhombohedral crystal, and the hexagonal crystal of the CPT, and being formed of tungsten (W) and oxygen (O) may be further randomly deficient.

However, the maximum value of $\gamma$ indicating O deficiency in the above general formula is preferably 0.46, as described above. This is because when the CPT is excessively reduced to cause excessive oxygen deficiency, the hexagonal $WO_6$ skeleton may decompose, and $WO_2$ and metal W, which are lower oxides, may be precipitated.

In the CPT crystals, one or more types selected from excess $O^{2-}$, OH-, and $OH_2$ may be placed in a portion of one or more voids selected from hexagonal tunnel voids in the orthorhombic crystal or in the hexagonal crystal and pyrochlore voids in the rhombohedral crystal.

When the CPT film is deposited in an oxygen-containing atmosphere, oxygen is likely to be taken into the film. Further, when dry deposition is performed in a vacuum, a small amount of water in the vacuum may be taken into the film. It is well known that in sputtering deposition, $N_2$ gas and $O_2$ gas contain a small amount of water and there is adsorbed water on the inner wall of the reaction chamber where sputtering is performed, so that water is absorbed into the film during the deposition.

The hexagonal tunnel of the CPT crystal penetrates in the c-axis direction, with alternating gaps called hexagonal cavities and hexagonal windows. Cs is usually present in the hexagonal cavity. The hexagonal window site has extra voids where oxygen and water can enter, so the invading oxygen and water are easily taken up as described above, but the electronic effect thereof is significant.

When $O^{2-}$ or OH~ enters the hexagonal window, $H^+$ (proton) or $H_3O^+$ (oxonium ion) that simultaneously enter the system eliminate some of W and Cs. Therefore, the electrons supplied to the conduction band (CB) by W and Cs are reduced. The $O^{2-}$, OH~, and $OH_2$ can also displace Cs in the hexagonal cavity, and the electrons in the conduction band are reduced in this case as well.

When $OH_2$, which is charge neutral, enters the hexagonal window site, there is a possibility that due to the size effect, a Cs deficiency may be induced in the adjacent hexagonal cavity in the c-axis direction. As a result, the electrons in the conduction band are reduced as in the case of $O^{2-}$ and OH-.

The CPT with the rhombohedral structure also has similar voids called pyrochlore cavities, which can accept the entry of water and oxygen in the same manner as described above. The electronic effect thereof is similar.

Thus, the entry of $O^{2-}$, OH-, and $OH_2$ causes a reduction of the electrons in the conduction band. However, when oxygen and water are abundant during crystallization, due to the presence of protons and oxonium, a structure with W and Cs deficiency is formed in order to maintain the local charge balance within the crystal. That is, at least some of the tungsten and cesium deficiencies in the CPT crystals are caused by or one or more types selected from $O^{2-}$, OH-, and $OH_2$ that have entered the hexagonal window site, the hexagonal cavity site, or the pyrochlore void.

The lattice constant of the CPT that is converted to a hexagonal conversion value is not particularly limited, but it is preferable that the c-axis is $7.61 \text{ Å} \leq c \leq 7.73$ Å and the a-axis is $7.38 \text{ Å} \leq a \leq 7.53$ Å.

In this case, the lattice constant of each phase may be determined by Rietveld analysis and the like, and may be converted to the hexagonal conversion value. Because the orthorhombic crystal is a hexagonal crystal with a lattice defect plane as described above, the lattice constant of the orthorhombic crystal may be converted to the lattice constant of the hexagonal crystal by an appropriate lattice correspondence model. Assuming the model of Solodovnikov 1998 (NPL 1) for the correspondence of lattice changes between the orthorhombic and hexagonal crystals, the relations $a_{orth} = 2a_{hex}$, $b_{orth}^2 = 48a_{hex}^2$, and $c_{orth} = c_{hex}$ are extracted from the geometric relations for the model. The lattice constants, all of which are converted to the hexagonal conversion values, are determined using these equations. For the rhombohedral crystal, the hexagonal lattice constant may be obtained from $a_{hex} = 2a_{rhom}\sin(\alpha/2)$ and $c_{hex}^2 = 3a_{rhom}^2(3-4\sin^2(\alpha/2))$. In the above equations, $a_{orth}$, $b_{orth}$, and $c_{orth}$ refer to the respective lengths of the a-axis, b-axis, and c-axis of the orthorhombic crystal, $a_{hex}$, $b_{hex}$, and $c_{hex}$ refer to the respective lengths of the a-axis, b-axis, and c-axis of the hexagonal crystal. $a_{rhom}$ and $\alpha$ refer to the lattice constant and interaxial angle of the rhombohedral crystal, respectively.

The lattice constant changes as the amount of electrons of the W-5d orbital in the lower part of the conduction band changes, affecting the pseudo Jahn-Teller distortion of the $WO_6$ octahedron. The lattice constant also changes as the amount of the tungsten deficiency or the cesium deficiency. Thus, by setting the lattice constant within the above range, the amount of the tungsten deficiency or the cesium deficiency can be set within an appropriate range, for example.

(3) Optical Characteristics

The optical characteristics of the near-infrared shielding film according to the present embodiment as the solar radiation shielding film are not particularly limited, but it is preferable that the optical characteristics satisfy $\eta \leq 0.005$ VLT + 0.3 ($\eta$: solar heat gain coefficient, VLT: visible light transmittance).

For a given VLT value, the smaller the η value, the better. The characteristics represented by the above formula exceed the characteristics of heat ray absorbing glass, heat ray reflecting glass, and ATO fine particle dispersion films available on the market. By preparing a CPT film suitable as the near-infrared shielding film, it is possible to lower the η value and to obtain performance comparable to that of an ITO sputter film and a resin multilayer heat ray reflecting film.

(4) Surface Resistance Value

The surface resistance value of the near-infrared shielding film according to the present embodiment is not particularly limited, but may be $10^5$ Ω/□ or more. Such a surface resistance value can never be obtained with metal multilayer films or ITO sputter films, which are based on the principle of plasma reflection of free electrons. Such a surface resistance value is obtained because the principle of the near-infrared absorption is interband transition of bound electrons in the CPT crystal.

In the CPT crystal of the near-infrared shielding film according to the present embodiment, bound electrons are present at the lower part of the conduction band. The bound electrons are localized around the $W^{5+}$ cation, and movement of the bound electrons in a solid in response to external voltage (potential) is caused by electron hopping and tunneling effects, which generally results in extremely slow movement speeds compared to free electrons. In addition, the long-range interaction of the localized electrons reduces the density of electronic states at Fermi energy. This effect is known as the Coulomb gap. The lower the density of the bound electrons in the lower part of the conduction band, the greater the synergistic effects of electron localization and the Coulomb gap, and this reduces the conductivity of the thin film. Conversely, the smaller the tungsten and cesium deficiency, the more free and bound electrons are injected into the conduction band, increasing the conductivity of the film. As the number of oxygen deficiencies increases, the amount of bound electrons increases and the conductivity of the film also increases.

(5) Film Thickness

The film thickness of the near-infrared shielding film according to the present embodiment is not particularly limited, but is preferably 30 nm or more and 1,200 nm or less. The near-infrared shielding film according to the present embodiment is a film obtained by sputtering deposition or the like as will be described later, and can be formed thin and evenly without using a dispersing agent or a medium resin.

By setting the thickness of the near-infrared shielding film according to the present embodiment to 30 nm or more, the light absorption effect in the near-infrared light region can be sufficiently exerted.

By setting the thickness of the near-infrared shielding film according to the present embodiment to 1,200 nm or less, the coloration of the film can be prevented while maintaining sufficient heat ray shielding performance. In addition, the amount of target used during production can be reduced, and sputtering deposition time can be decreased, thereby increasing productivity.

The near-infrared shielding film according to the present embodiment can have optical characteristics in which the transmittance in the visible light region (wavelength 400 nm or more and 780 nm or less) is higher than the transmittance in the near-infrared light region (wavelength 780 nm or more and 1,400 nm or less).

In the near-infrared shielding film according to the present embodiment, when the transmittance at a wavelength of 550 nm is 50% or more, the transmittance at a wavelength of 1,400 nm is 20% or less. In the near-infrared shielding film according to the present embodiment, when the transmittance at a wavelength of 550 nm is 30% or more and less than 50%, the transmittance at a wavelength of 1,400 nm is 5% or less.

When the near-infrared shielding film according to the present embodiment is composed of the continuous film of the cesium tungsten composite oxide including one or more crystals selected from the orthorhombic crystal, the rhombohedral crystal, and the hexagonal crystal within the atomic composition ratio of Cs, W, and O described above, the transmittance in the near-infrared light region can be lower than the transmittance in the visible light region, even when the transmittance at a wavelength of 550 nm is freely set.

[Method for Producing Near-Infrared Shielding Film]

Next, a method for producing a near-infrared shielding film according to the present embodiment will be described. The near-infrared shielding film described above can be produced by the method for producing the near-infrared shielding film according to the present embodiment. Therefore, some of the items already explained will be omitted.

The method for producing the near-infrared shielding film according to the present embodiment may include the following steps, as illustrated in a flow diagram 10 of FIG. 1.

A deposition step (S1) of depositing a pre-heat-treatment film on a substrate by a dry method.

A heat treatment step (S2) in which the pre-heat-treatment film is heat treated at a temperature of 400°C or more and less than 1,000°C to form a continuous film of cesium tungsten composite oxide.

The cesium tungsten composite oxide obtained after the heat treatment step is represented by a general formula $Cs_xW_yO_z$ ($4.8 \leq x \leq 14.6$, $20.0 \leq y \leq 26.7$, $62.2 \leq z \leq 71.4$, and $x + y + z = 100$). The continuous film includes one or more crystals selected from the orthorhombic crystal, the rhombohedral crystal, and the hexagonal crystal.

As the dry method, a sputtering method or a vacuum deposition method may be used.

Hereinafter, each step will be described in detail with reference to the case where the film is formed by the sputtering method.

(1) Deposition Step

In the deposition step S1, the pre-heat-treatment film may be deposited on the substrate by the sputtering method.

The target used in depositing the pre-heat-treatment film is not particularly limited, but the film may be deposited using, for example, a cesium oxide tungsten sintered body target.

As for the composition of the target used in depositing the pre-heat-treatment film, it is preferable that Cs/W, which is the ratio of the mole number of cesium (Cs) and tungsten (W) contained, is 0.2 or more and 0.7 or less. This is because the composition of the target used in depositing is reflected in Cs/W, which is the ratio of the mole number of cesium (Cs) and tungsten (W) contained in the film to be deposited.

The crystal structure of the target is not particularly limited because it does not directly affect the crystal structure of the film to be deposited. The target preferably has a relative density of 70% or more and a specific resistance of 1 $\Omega \cdot cm$ or less.

The method for producing the target described above is not particularly limited, but may be prepared, for example, by hot press sintering of a cesium tungsten composite oxide powder in a vacuum or an inert atmosphere. This is because the sintered body produced in this manner is strong enough to withstand the machining in producing the target and the brazing temperature during bonding, and is conductive enough to allow DC sputtering.

Examples of the deposition method for the pre-heat-treatment film includes the sputtering method, as described above. When the sputtering method is used as the deposition method, a DC sputtering deposition method is preferable in which a DC voltage or a pulse voltage is applied to the target. This is because the deposition speed is high and the productivity is excellent.

The substrate on which the pre-heat-treatment film is deposited is not particularly limited, but one or more types selected from a transparent heat-resistant polymer film and glass may be used, for example. As the substrate, glass is particularly preferable. This is because glass is transparent to light in the visible light region and is not deteriorated or deformed in the subsequent heat treatment step S2.

When glass is used as the substrate, the thickness of the glass is not particularly limited, and any thickness normally used for architectural window glass, automotive glass, display devices, or the like may be used without any particular limitation. The thickness of the glass is preferably 0.1 mm or more and 10 mm or less, for example.

In depositing the pre-heat-treatment film, the sputter gas is not particularly limited, but argon gas or a mixture gas of argon and oxygen may be used, for example.

Whether the argon gas or the mixture gas is used in the deposition step may be selected depending on the conditions of the subsequent heat treatment step S2.

When the mixture gas is used in the deposition step, the oxygen concentration is not particularly limited, but it is preferable that the oxygen concentration in the mixture gas is less than 20 vol%, and more preferably 5 vol% or more and 10 vol% or less, because when the oxygen concentration in the mixture gas is high, the deposition rate decreases and productivity decreases.

When the argon gas is used as the sputter gas, it is preferable that the argon gas purity is 99 vol% or more and that the oxygen concentration is less than 1 vol%.

The pre-heat-treatment film obtained in the deposition step is usually amorphous, but the diffraction peak based on a crystal may appear when the X-ray diffraction measurement is performed. The predetermined crystal structure, such as the hexagonal crystal, is formed in the subsequent heat treatment step S2.

(2) Heat Treatment Step

Next, in the heat treatment step S2, the pre-heat-treatment film obtained in the deposition step S1 may be heat treated at a temperature of 400°C or more and less than 1,000°C to form a continuous film of cesium tungsten composite oxide. By the heat treatment of the pre-heat-treatment film, a crystal structure including one or more crystals selected from the orthorhombic crystal, the rhombohedral crystal, and the hexagonal crystal, may be formed.

In the heat treatment step, the heat treatment may be performed by selecting the atmosphere according to the gas at the time of the sputtering deposition, so that the oxygen concentration in the CPT film is within an appropriate range.

As described above, in the deposition step S1, the gas containing oxygen may be used as the sputter gas. For example, any of the deposition step S1 and the heat treatment step S2 may be performed under an atmosphere containing oxygen.

As described above, by performing either of the deposition step S1 and the heat treatment step S2 under an atmosphere containing oxygen, a cesium tungsten oxide film having high heat ray shielding performance can be obtained.

Hereinafter, suitable conditions of the heat treatment step will be described according to the conditions of the deposition step.

(When Mixture Gas of Argon and Oxygen is Used as Sputter Gas in Deposition Step)

When the deposition is performed using the mixture gas of argon and oxygen as the sputter gas in the deposition step S1, it is preferable that the heat treatment of the film in the heat treatment step S2 is performed at a temperature of 400°C or more and less than 1,000°C in an inert gas atmosphere or in a reducing atmosphere. Examples of the inert gas atmosphere or the reducing atmosphere include a nitrogen gas, an argon gas, a mixture gas of hydrogen and nitrogen, a mixture gas of hydrogen and argon, or the like.

When the deposition is performed using the mixture gas of argon and oxygen as the sputter gas in the deposition step S1, in a case where the heat treatment is performed in an oxidizing atmosphere such as air, oxygen, and the like, in the heat treatment step S2, the oxidation of the film may progress excessively. In this case, the oxygen vacancies in the CPT contained in the obtained CPT film is reduced, and the crystal structure changes to the orthorhombic crystal or rhombic crystal in which tungsten deficiency and cesium deficiency are abundant. As a result, electrons are depleted in the lower part of the conduction band, and the film becomes an insulator, which may reduce the heat ray shielding performance. Therefore, in this case, it is preferable to perform the heat treatment in an inert gas atmosphere or a reducing atmosphere, as described above.

In this case, by setting the heat treatment temperature to 400°C or higher, the obtained CPT film is crystallized and defects can be eliminated. Accordingly, a near-infrared shielding film having an appropriate band structure and electrons in the lower part of the conduction band and having excellent heat ray shielding performance can be obtained.

The crystal structures of the orthorhombic crystal, the rhombohedral crystal, or the hexagonal crystal is maintained even at a high temperature of 900°C or more in an inert gas atmosphere or a reducing atmosphere. However, when the heat treatment temperature is more than 1,000°C, there is a risk that the CPT film will deteriorate due to the reaction between the CPT film and the substrate, or that the film will disappear due to peeling. At such a high temperature, there is a possibility of deformation even when glass is used as the substrate. Therefore, the heat treatment temperature is preferably less than 1,000°C.

The heat treatment time is not particularly limited, but may be 10 minutes or more and 60 minutes or less, so that the formation of the orthorhombic crystal, the rhombohedral crystal, or the hexagonal crystal proceeds rapidly.

(When Only Argon is Used for Sputter Gas in Deposition Step)

When the deposition is performed using only the argon gas in the deposition step S1, it is considered that the oxygen concentration in the film is moderate or insufficient. Therefore, in the heat treatment step S2, a CPT film having heat ray shielding performance can be obtained even when the heat treatment is performed in an inert gas atmosphere such as nitrogen gas that does not contain oxygen. When the heat treatment is performed with the inert gas such as nitrogen gas that does not contain oxygen, heat ray shielding performance can be obtained over a wide temperature range.

In this case, the pre-heat-treatment film may be heat treated in an oxidizing atmosphere containing oxygen in the heat treatment step. When the heat treatment is performed in the oxidizing atmosphere containing oxygen, the oxygen concentration in the film can be maintained in a more appropriate range, and the heat ray shielding performance can be further enhanced. Therefore, in this case, the heat treatment may be performed in an oxygen-containing atmosphere having an oxygen concentration of 5 vol% or more and 20 vol% or less in the heat treatment step S2, for example. It is more preferable to select air as the heat treatment atmosphere, for example.

When the heat treatment step is performed in an air atmosphere, the heat treatment furnace to be used need not be of a special sealed structure.

When the heat treatment is performed in the oxygen-containing atmosphere as described above, the heat treatment temperature is preferably 400°C or more and 600°C or less. By setting the heat treatment temperature to 400°C or more, the obtained CPT film is crystallized, and a near-infrared shielding film having excellent heat ray shielding performance is obtained. By setting the heat treatment temperature to 600°C or less, the excessive oxidation of the obtained CPT film can be prevented. Accordingly, the amount of electrons in the lower part of the conduction band can be appropriate, for example, and the heat ray shielding performance can be enhanced.

The heat treatment time is not particularly limited, but may be 10 minutes or more and 60 minutes or less, so that the formation of the orthorhombic crystal, the rhombohedral crystal, or the hexagonal crystal proceeds rapidly.

As described above, according to the method for producing the near-infrared shielding film according to the present embodiment, the near-infrared shielding film described above can be obtained.

Therefore, the near-infrared shielding film obtained by the method for producing the near-infrared shielding film according to the present embodiment can have the characteristics described above with regard to the near-infrared shielding film.

[Example]

Hereinafter, the present invention will be described in detail with reference to examples. The present invention is not limited to the following examples.

(Evaluation Method)

The evaluation methods in the following Examples and Comparative Examples will be described below.

(1) Surface Resistance

The surface resistance of the obtained near-infrared shielding film was measured using Loresta-GX and Hiresta-UX manufactured by Mitsubishi Chemical Corporation.

(2) Film Thickness

The film thickness of the obtained near-infrared shielding film was measured using a step meter (Alpha-Step IQ, manufactured by KLA-Tencor).

(3) X-ray Diffraction Pattern and Lattice Constant

The X-ray diffraction pattern was measured using an X-ray diffractometer D2 PHASER manufactured by Bruker AXS using Cu-K$\alpha$ radiation as a radiation source. The lattice constant of the crystal phase was obtained by the Pawley method assuming a space group of P6$_3$/mcm using calculation software DIFFRAC TOPAS manufactured by Bruker AXS.

(4) Optical Characteristics

Regarding the optical characteristics of the obtained near-infrared shielding film, transmittance and 8° incident diffuse reflectance were measured using a spectrophotometer (V-670 manufactured by JASCO Corporation).

Using spectral data of transmittance and reflectance, the visible light transmittance (VLT), the solar transmittance (ST25), and the solar reflectance (SR25) were obtained in accordance with JIS R 3106-1998, and the solar heat gain coefficient ($\eta$) was calculated in accordance with JIS R 3106-1998.

[Example 1]

A cesium carbonate solution and tungsten trioxide hydrate were mixed and kneaded in a ratio where the ratio of the mole numbers of cesium (Cs) and tungsten (W) contained was Cs/W = 0.33, and dried in the atmosphere at 100°C for 12 hours to prepare a precursor. The precursor was heated to 800°C in the atmosphere, held for 1 hour, and then slowly cooled to room temperature to obtain a white CPT powder. The obtained CPT powder was put into a hot press apparatus and sintered under the conditions of a vacuum atmosphere, a temperature of 950°C, and a pressing pressure of 250 kgf/cm$^2$, to produce a CPT sintered body.

As a result of chemical analysis of the composition of the CPT sintered body, Cs/W, which is the ratio of the mole numbers of cesium (Cs) and tungsten (W) contained, was 0.29. The CPT sintered body was ground by machining to have a diameter of 153 mm and a thickness of 5 mm, and bonded to a stainless steel backing plate using metallic indium brazing material to produce a CPT target.

The white CPT powder does not have an infrared shielding function, unlike the composite tungsten oxide powder YM-01, which is commercially available from Sumitomo Metal Mining Co., Ltd., and the like.

(Deposition Step: S1)

Next, the CPT target was attached to a sputtering device (model number SBH-2306, manufactured by ULVAC, Inc.), and a pre-heat-treatment film having a thickness of 400 nm was deposited on a glass substrate (EXG, manufactured by Corning, Inc., thickness 0.7 mm). When sputtering, the ultimate vacuum was set to 5×10$^{-3}$ Pa or less, and a mixture gas of 5 vol% oxygen and 95 vol% argon was used as the sputter gas. The sputter gas pressure was 0.6 Pa, and the input power was DC 600 W. As a result of X-ray diffraction measurement of the obtained pre-heat-treatment film, no diffraction peak was observed and the film was amorphous.

(Heat Treatment Step: S2)

The pre-heat-treatment film was placed in a lamp heating furnace (Model No. HP-2-9, manufactured by YONEKURA MFG. Co., Ltd.) and heat treated at 600°C for 30 minutes in a nitrogen atmosphere.

As a result of chemical analysis of the obtained CPT film, which is a near-infrared shielding film, Cs : W : O = 7.02 : 24.56 : 68.42 (atomic ratio) was obtained.

As a result of measuring the XRD pattern of the heat-treated film using the X-ray diffractometer, as illustrated in FIG. 2, diffraction peaks derived from the CPT of hexagonal Cs$_{0.32}$WO$_3$ were observed as the main phase, but diffraction peaks of orthorhombic Cs$_4$W$_{11}$O$_{35}$ and cubic (Cs$_2$O)$_{0.44}$W$_2$O$_6$ were also included.

The lattice constant of the crystal phase determined from the obtained XRD pattern was a = 7.39045 Å and c = 7.62665 Å.

As a result of measuring the surface resistance of the obtained CPT film, a value of 1.70 ×10$^{10}$ Ω/□ was obtained, confirming that it was nonconductive. In other words, it was confirmed that the film has excellent electromagnetic wave permeability. The term "electromagnetic wave" in the "electromagnetic wave permeability" as used herein means electromagnetic waves for various communication such as communication radio waves and broadcasting radio waves, and means, for example, electromagnetic waves in the MHz and GHz bands. The thickness of the CPT film was 396 nm.

As a result of measuring the spectral characteristics of the film, the transmission profile illustrated in FIG. 3A and the reflection profile illustrated in FIG. 3B were obtained. In the figures, for reference, the transmittance and reflectance of the pre-heat-treatment film before the heat treatment step are indicated as "as deposited".

According to FIGS. 3A and 3B, while the main visible portion with a wavelength in the range of 400 nm to 700 nm was highly transmitted, a large absorption of light in the near-infrared light region with a wavelength bottoming out around 1600 nm was observed. The reflection of light in the near-infrared region was not large at a level of 20% to 30%. Therefore, it was found that while maintaining sufficient transparency in the visible light region, high heat ray shielding performance is achieved by absorbing light in the infrared light region.

The solar heat gain coefficient and the visible light transmittance of the near-infrared shielding film obtained in the present Example were η = 0.550 and VLT = 66.18%. When the above values were plotted on the η-VLT graph illustrated in FIG. 12, it was confirmed that the values were below the following equation (1).

$$\eta = 0.005 \ VLT + 0.3 \ \dots \ (1)$$

It can be confirmed from FIG. 12 that, even though the obtained near-infrared shielding film is a heat ray absorbing film, the characteristics of the film are close to those of an ITO sputter film that reflects infrared light. This is because, as illustrated in FIGS. 3A and 3B, the CPT film obtained in the present Example shields light in the near-infrared region of shorter wavelength compared to the case of the ITO film. In addition, it was found that the CPT film obtained in the present Example is brighter and has better solar radiation shielding characteristics compared to the heat ray absorbing glass and the ATO fine particle dispersion film.

(Observation of STEM-HAADF)

From the obtained near-infrared shielding film, a cross-sectional thin section sample is prepared using a focused ion beam (FIB) device. Then, Z-contrast atomic image observation was performed using a transmission electron microscope (HF-2200, manufactured by Hitachi High-Tech Corporation) in the high angle annular dark field scanning transmission electron microscopy (STEM-HAADF) mode. Because the HAADF image uses high-angle diffraction waves, the larger the atomic number, the stronger the atomic spot image. The results of the observations are illustrated in FIG. 4.

In the STEM-HAADF image in FIG. 4 (A), dark linear contrasts and various defect contrasts that are similar to the patterns indicated in FIG. 4 (A), are observed. From the selected area diffraction pattern of FIG. 4 (B), these traces are identified as hexagonal prism planes (100), (010), and (110). As in FIG. 7, which is the measurement result of Example 2 described below, the change in atomic spot intensity indicates the following: in the dark linear contrast area of a field 1 in FIG. 4 (A), which is illustrated in FIG. 4(C), part of Cs is deficient; and the dark linear contrast area of a field 2 in FIG. 4 (A), which is illustrated in FIG. 4 (D), indicates W and Cs deficiency. The arrowed portion of a field 3 in FIG. 4 (A), which is illustrated in FIG. 4(E), indicates that W or Cs is deficient in a point-like pattern.

[Example 2]

(Deposition Step: S1)

Using the CPT target produced in Example 1, a pre-heat-treatment film having a thickness of 400 nm was deposited on the glass substrate under the same conditions as Example 1, except that a gas of 10 vol% oxygen and 90 vol% argon was used as the sputter gas. As a result of X-ray diffraction measurement of the obtained pre-heat-treatment film, no diffraction peak was observed, and the film was amorphous.

(Heat Treatment Step: S2)

The pre-heat-treatment film was placed in the same lamp heating furnace as that of Example 1 and heat treated at 800°C for 30 minutes in a nitrogen atmosphere.

As a result of chemical analysis of the obtained CPT film, which is a near-infrared shielding film, Cs : W : O = 8.45 : 23.94 : 67.61 (atomic ratio) was obtained.

As a result of measuring the XRD pattern of the heat-treated film using the X-ray diffractometer, as illustrated in FIG. 5, diffraction peaks derived from the CPT of hexagonal $Cs_{0.32}WO_3$ were observed as the main phase, but diffraction peaks of orthorhombic $Cs_4W_{11}O_{35}$ were included in considerably large amount, diffraction peaks of rhombohedral $Cs_{8.5}W_{15}O_{48}$ were slightly included, and diffraction peaks of cubic pyrochlore $(Cs_2O)_{0.44}W_2O_6$ were slightly included. The pyrochlore is considered to be a generated phase derived from taking in water during sputtering.

The lattice constant of the crystal phase determined from the obtained XRD pattern was a = 7.50611 Å and c = 7.72143 Å.

As a result of measuring the surface resistance of the obtained CPT film, a value of $3.20 \times 10^9 \ \Omega/\square$ was obtained, confirming that it was nonconductive. In other words, it was confirmed that the film has excellent electromagnetic wave permeability. The thickness of the CPT film was 405 nm.

As a result of measuring the spectral characteristics of the film, the transmission profile illustrated in FIG. 6A and the reflection profile illustrated in FIG. 6B were obtained. In the figures, for reference, the transmittance and reflectance of the pre-heat-treatment film before the heat treatment step are indicated as "as deposited".

According to FIGS. 6A and 6B, while the main visible portion with a wavelength in the range of 400 nm to 700 nm was highly transmitted, a large absorption of light in the near-infrared light region with a wavelength bottoming out around 1,900 nm was observed. The reflection of light in the near-infrared region was not large at a level of 10% to 30%. Therefore, it was found that while maintaining sufficient transparency in the visible light region, high heat ray shielding performance is achieved by absorbing light in the infrared light region.

The solar heat gain coefficient and the visible light transmittance of the near-infrared shielding film obtained in the present Example were $\eta$ = 0.595 and VLT = 67.32%. When the above values were plotted on the $\eta$-VLT graph illustrated in FIG. 12, it was confirmed that the values were below the equation (1) described above.

From the obtained near-infrared shielding film, a cross-sectional thin section sample is prepared using a focused ion beam (FIB) device. Then, Z-contrast atomic image observation was performed using a transmission electron microscope (HF-2200, manufactured by Hitachi High-Tech Corporation) in the high angle annular dark field scanning transmission electron microscopy (STEM-HAADF) mode. The results of the observations are illustrated in FIG. 7.

The STEM-HAADF image in FIG. 7 (A) is the atomic image as viewed in the $[001]_H$ direction of the hexagonal crystal. Because the HAADF image uses high-angle diffraction waves, the larger the atomic number, the stronger the atomic spot image. The dark linear traces observed in three directions are traces of hexagonal prism planes (100), (010), and (110), as determined from the selected area diffraction pattern of FIG. 7 (B). As illustrated in the atomic arrangement schematic diagram attached to FIGS. 7 (A) and 7 (B), in the hexagonal prism plane, the atomic plane of Cs-W-Cs alternates with the atomic plane of W-O-W, but the spots of Cs atoms appear darker than the spots of W atoms, so that the atomic planes can be distinguished. In FIG. 7 (C), which is an enlarged view of the frame in the field of view, when the brightness change of the atomic spots are taken along the arrows of A, B, and C within the dotted box, in the dark linear trace areas along $(010)_H$, W and Cs were found to be dark and deficient, as illustrated in FIGS. 7 (D), 7 (E), and 7 (F), respectively. The W- and Cs-deficient planes are relatively regular, confirming that the structure is similar to orthorhombic $Cs_4W_{11}O_{35}$. Furthermore, when the intervals of the atomic spots were measured along the arrows of A, B, and C, the spot interval was 9.10 longer in the W- and Cs-deficient region than in the normal region. This indicates that, due to the deficiencies of W and Cs, the gap of the deficient planes expands by the ion repulsion effect of the atoms on both sides of the deficient plane, and thus the orthorhombic b-axis is slightly longer than that of the hexagonal crystal. In other words, the presence of W and Cs deficiencies reduced the symmetry so that the hexagonal crystal became orthorhombic. In addition, in this sample, although not illustrated in this HAADF image, modulation was also observed in some places in the c-plane stack of the bottom, which may be the reason the XRD peaks of the rhombohedral $Cs_{8.5}W_{15}O_{48}$ were slightly included.

[Example 3]

(Deposition Step: S1)

Using the CPT target produced in Example 1, a pre-heat-treatment film having a thickness of 400 nm was deposited on the glass substrate under the same conditions as Example 1, except that a gas of 0 vol% oxygen and 100 vol% argon was used as the sputter gas. As a result of X-ray diffraction measurement of the obtained pre-heat-treatment film, no diffraction peak was observed, and the film was amorphous.

(Heat Treatment Step: S2)

The pre-heat-treatment film was placed in the same lamp heating furnace as that of Example 1 and heat treated at 600°C for 30 minutes in a nitrogen atmosphere.

As a result of chemical analysis of the obtained CPT film, which is a near-infrared shielding film, Cs : W : O = 9.84 : 22.95 :67.21 (atomic ratio) was obtained.

As a result of measuring the XRD pattern of the heat-treated film using the X-ray diffractometer, as illustrated in FIG. 8, diffraction peaks derived from the CPT of hexagonal $Cs_{0.32}WO_3$ were observed as almost a single phase.

The lattice constant of the crystal phase was a = 7.41586 Å and c = 7.62271 Å.

As a result of measuring the surface resistance of the obtained CPT film, a value of $2.30 \times 10^7$ $\Omega/\square$ was obtained, confirming that it was nonconductive. In other words, it was confirmed that the film has excellent electromagnetic wave permeability. The thickness of the CPT film was 405 nm.

As a result of measuring the spectral characteristics of the film, the transmission profile illustrated in FIG. 9A and the reflection profile illustrated in FIG. 9B were obtained. In the figures, for reference, the transmittance and reflectance of the pre-heat-treatment film before the heat treatment step are indicated as "as deposited".

According to FIGS. 9A and 9B, while the main visible portion with a wavelength in the range of 400 nm to 700 nm was highly transmitted, an absorption of light in the near-infrared region with a wavelength of 780 nm or more was observed. The reflection of light in the near-infrared region was relatively large at a level of 30% to 50%, but most of the light blocking in the near-infrared region are due to absorption. Using spectral data of transmittance and reflectance, VLT was determined to be VLT = 32.79%, which was low, but when the film thickness was decreased, VLT was readily increased to the 70% level. Therefore, it was found that, in the near-infrared shielding film obtained in the present embodiment, while maintaining sufficient transparency in the visible light region, high heat ray shielding performance is achieved by absorbing light in the infrared light region.

The solar heat gain coefficient and the visible light transmittance of the near-infrared shielding film obtained in the present Example were $\eta = 0.361$. When the above value was plotted on the $\eta$-VLT graph illustrated in FIG. 12, it was confirmed that the value was below the equation (1) described above. Thus, it was found that the near-infrared shielding film obtained in the present Example has much higher characteristics than commercially available heat absorbing films and has solar radiation shielding characteristics that are comparable to or higher than ITO sputter films.

[Example 4]

(Deposition Step: S1)

Using the CPT target produced in Example 1, a pre-heat-treatment film having a thickness of 400 nm was deposited on the glass substrate under the same conditions as Example 1, except that a gas of 0 vol% oxygen and 100 vol% argon was used as the sputter gas. As a result of X-ray diffraction measurement of the obtained pre-heat-treatment film, no diffraction peak was observed, and the film was amorphous.

(Heat Treatment Step: S2)

The pre-heat-treatment film was placed in the same lamp heating furnace as that of Example 1 and heat treated at 460°C for 30 minutes in the atmosphere.
As a result of chemical analysis of the obtained CPT film, which is a near-infrared shielding film, Cs : W : O = 9.63 : 22.05 : 68.32 (mole number ratio) was obtained.
As a result of measuring the XRD pattern of the heat-treated film using the X-ray diffractometer, as illustrated in FIG. 10, diffraction peaks of hexagonal $Cs_{0.32}WO_3$ were observed as the main phase, but diffraction peaks of orthorhombic $Cs_4W_{11}O_{35}$ and rhombohedral $Cs_{8.5}W_{15}O_{48}$ were included, and diffraction peaks of cubic pyrochlore $(Cs_2O)_{0.44}W_2O_6$ were also observed. The peak positions and intensities of the rhombohedral and pyrochlore phases deviate from the values in the database, suggesting that they were modulated by W and Cs lattice defects.
The lattice constant of the main crystal phase was a = 7.42783 Å and c = 7.62911 Å.
As a result of measuring the surface resistance of the obtained CPT film, a value of $3.83 \times 10^6$ $\Omega/\square$ was obtained, confirming that it was nonconductive. In other words, it was confirmed that the film has excellent electromagnetic wave permeability. The thickness of the CPT film was 398 nm.
As a result of measuring the spectral characteristics of the film, the transmission profile illustrated in FIG. 11A and the reflection profile illustrated in FIG. 11B were obtained. In the figures, for reference, the transmittance and reflectance of the pre-heat-treatment film before the heat treatment step are illustrated as "as deposited".

According to FIGS. 11A and 11B, while the main visible portion with a wavelength in the range of 400 nm to 700 nm was highly transmitted, a profile was observed in which all light in the near-infrared region with wavelength of 1,000 nm or more was blocked. The reflection of light in the near-infrared region was relatively large at a level of 30% to 40%, but most of the light blocking in the near-infrared region are due to absorption. Therefore, it was found that, in the film, while maintaining sufficient transparency in the visible light region, high heat ray shielding performance is achieved by absorbing light in the infrared light region.
The solar heat gain coefficient and the visible light transmittance of the near-infrared shielding film obtained in this Example were $\eta=0.465$ and VLT=57.35%. When the above values were plotted on the $\eta$-VLT graph illustrated in FIG. 12, it was confirmed that the values were below the equation (1) described above. Thus, it was found that the near-infrared shielding film obtained in the present Example has much higher characteristics than commercially available heat absorbing films or ATO fine particle dispersion films, and has solar radiation shielding characteristics that are comparable to or higher than ITO sputter films.

[Comparative Example 1]

Using the CPT target produced in Example 1, a pre-heat-treatment film having a thickness of 400 nm was deposited on the glass substrate under the same conditions as Example 1. However, the heat treatment step was not performed.
Cs/W, which is the atomic ratio of the mole numbers of cesium (Cs) and tungsten (W) contained in the obtained film, was 0.29. As a result of X-ray diffraction analysis of the film, no diffraction peak was observed, and the film was amorphous.
The transmittance and reflectance of the obtained film is illustrated as "as deposited" in FIGS. 3A and 3B. In the obtained film, the transmittance in visible light at a wavelength of 550 nm was more than 60%. However, the transmittance in infrared light at a wavelength of 1,400 nm was also more than 60%, and did not shield the infrared light. The ratio of the transmittance at a wavelength of 1,400 nm to the transmittance at a wavelength of 550 nm was high at 1.00. Therefore, it was confirmed that the heat ray shielding performance was almost not exhibited.

[XPS-W4f spectrum]

Reference Example 1, Reference Example 2, and cesium tungsten composite oxide powder were prepared in addition to the near-infrared shielding films produced in Examples 1 to 3, and the XPS-W4f spectrum was measured.
The film of Reference Example 1 was prepared by the following procedure.

Using the CPT target produced in Example 1, a pre-heat-treatment film having a thickness of 400 nm was deposited on the glass substrate under the same conditions as Example 1, except that a gas of 10 vol% oxygen and 90 vol% argon was used as the sputter gas.

The obtained pre-heat-treatment film was placed in the same lamp heating furnace as that of Example 1, and heat treated at 540°C for 30 minutes in an atmosphere of 1 vol% hydrogen and the remainder nitrogen.

The film of Reference Example 2 was prepared by the following procedure.

Using the CPT target produced in Example 1, a pre-heat-treatment film having a thickness of 400 nm was deposited on the glass substrate under the same conditions as Example 1, except that a gas of 10 vol% oxygen and 90 vol% argon was used as the sputter gas.

The obtained pre-heat-treatment film was placed in the same lamp heating furnace as that of Example 1, and heat treated at 600°C for 30 minutes in a nitrogen atmosphere.

The cesium tungsten composite oxide powder was produced as follows. A cesium carbonate solution and tungsten trioxide hydrate were mixed and kneaded in a ratio where the ratio of the mole numbers of cesium (Cs) and tungsten (W) contained was Cs/W = 0.33, and dried in the atmosphere at 100°C for 12 hours to prepare a precursor. The precursor was heated to 800°C in an atmosphere of 1 vol% hydrogen and the remainder nitrogen, held for 1 hour, and then slowly cooled to room temperature.

The results are illustrated in FIG. 13A. The XPS-W4f spectrum of the sputter film consists of four peaks including $W^{6+}$, $W^{5+}$, and their split doublets produced by the spin-orbit interaction, with $W^{6+}_{7/2}$ being the maximum peak. When the spectrum is separated into four asymmetric peaks based on a Gaussian curve, the amounts of $W^{6+}$ and $W^{5+}$ varied among samples. When the amount of $W^{5+}$ is increased, $W^{6+}$ tends to decrease. As illustrated in FIG. 13B, the order of the results from the lowest $W^{5+}$ was, Reference Example 2, Example 1, Example 2, Reference Example 1, and Example 3. In the near-infrared shielding film described above, $V_o$ (oxygen deficiency) is increased in the order described above, and bound electrons are considered to be supplied to the lower part of the conduction band. In support of this, the specific resistance of the near-infrared shielding film decreased in the order of Example 1, Example 2, and Example 3, consistent with the order of increase in $W^{5+}$.

[XPS-O1s spectrum]

The XPS-O1s spectrum was measured on the same sample as for the XPS-W4f spectrum. The results are illustrated in FIG. 14A. In all samples, the XPS-O1s spectrum was observed to have a tail on the high energy side.

The composition of the O1s spectrum of the CPT was peak-separated by assuming that the spectrum is composed of three groups of: the first peak $O-W^{6+}$ (530.29 eV or more and 530.61 eV or less), the second peak O-H and $O-W^{5+}$ (531.47 eV or more and 531.76 eV or less), and the third peak $O-H_2$ (532.80 eV), from the lowest binding energy. FIG. 14B illustrates the area percentages of the second peak and the third peak. It can be seen that the second peak of the near-infrared shielding film increases in order of increasing conductivity of the film. In other words, it is considered that, although the influence of O-H was included in the second peak, the contribution of $O-W^{5+}$ is superimposed, thereby increasing the peak area in the order of the increase in $W^{5+}$.

In all of the sputter films, the $O-H_2$ peak, which is the third peak, was larger than that of the fully reduced cesium tungsten composite oxide powder. This result is evidence that water contained in the vacuum is taken into the film during sputtering deposition.

[XPS Valence Band Observation]

The valence band and the lower part of the conduction band of the near-infrared shielding films obtained in Example 1 and Example 2 were observed by XPS. The results of Example 1 are illustrated in FIGS. 15A and 15C, and the results of Example 2 are illustrated in FIGS. 15B and 15D. FIGS. 15C and 15D are enlarged views of FIGS. 15A and 15B, respectively.

The measurement results of the samples are also illustrated as "CPT 800°C 15 min" or "CPT 800°C 60 min" in the figures, in which $Cs_4W_{11}O_{35}$, which is an orthorhombic CPT powder, is heated and reduced at 800°C for 15 minutes or 60 minutes in an atmosphere of 1 vol% $H_2$ and the remainder $N_2$.

In both the samples of Example 1 and Example 2, the presence of electrons was confirmed at the bottom of the conduction band (CB). In contrast, in the sample of the CPT powder heated for 60 minutes, compared to the samples of Examples 1 and 2, the Cs-5p in the valence band increased, the O-2p decreased, and the W-5d peak in the conduction band increased, as illustrated in FIGS. 15C and 15D. In the samples of the CPT powder heated for 15 minutes, the peaks were found to be almost identical to that of the samples of Examples 1 and 2.

In the near-infrared shielding film of Examples 1 and 2, the peak position of the lowest part of the conduction band (CB) is shifted toward the valence band compared to the CPT powder that was heated for 60 minutes and reduced, so the effect of the Coulomb gap is observed. Therefore, it can be interpreted that the conductivity of the film is reduced.

Although the near-infrared shielding film and the method for producing the near-infrared shielding film have been described with reference to the embodiments and examples, and the like, the present invention is not limited to the above-described embodiments and the embodiments. Various modifications and changes are possible within the scope of the present invention described in the claims.

The present application claims priority to Japanese Patent Application No. 2020-143002, filed August 26, 2020, with the Japanese Patent Office. The contents of which are incorporated herein by reference in their entirety.

## Claims

1. A near-infrared shielding film comprising a continuous film of a cesium tungsten composite oxide represented by a general formula $Cs_xW_yO_z$, where $4.8 \leq x \leq 14.6$, $20.0 \leq y \leq 26.7$, $62.2 \leq z \leq 71.4$, and $x + y + z = 100$, wherein
the continuous film includes one or more crystals selected from an orthorhombic crystal, a rhombohedral crystal, and a hexagonal crystal.

2. The near-infrared shielding film according to claim 1, wherein

   the orthorhombic crystal and the hexagonal crystal are linked by a lattice correspondence of $(001)H//(001)R$, $(110)H//(100)R$, and $(-110)H//(010)R$, where H and R represent the hexagonal crystal and the orthorhombic crystal, respectively, and
   a planar or linear lattice defect is included in at least part of a (010)R plane of the orthorhombic crystal, or one or more planes selected from a prism plane [(100)H, (010)H, (110)H] and a basal plane (001)H of the hexagonal crystal.

3. The near-infrared shielding film according to claim 2, wherein the lattice defect includes one or more types selected from a tungsten deficiency and a cesium deficiency.

4. The near-infrared shielding film according to claim 2 or 3, wherein a portion of oxygen of a W-O octahedron is further randomly deficient, the W-O octahedron constituting the one or more crystals selected from the orthorhombic crystal, the rhombohedral crystal, and the hexagonal crystal, and being formed of tungsten (W) and oxygen (O).

5. The near-infrared shielding film according to any one of claims 1 to 4, wherein one or more types selected from excess $O^{2-}$, OH-, and $OH_2$ are placed in one or more voids selected from hexagonal tunnel voids in the orthorhombic crystal or in the hexagonal crystal and pyrochlore voids in the rhombohedral crystal.

6. The near-infrared shielding film according to any one of claims 1 to 5, wherein a lattice constant of the cesium tungsten composite oxide that is converted to a hexagonal conversion value is $7.61 \text{ Å} \leq c \leq 7.73$

Å and $7.38 \text{ Å} \leq a \leq 7.53 \text{ Å}$.

7. The near-infrared shielding film according to any one of claims 1 to 6, wherein optical characteristics satisfy $\eta \leq 0.005$ VLT + 0.3, where $\eta$ is a solar heat gain coefficient and VLT is a visible light transmittance.

8. The near-infrared shielding film according to any one of claims 1 to 7, wherein a surface resistance value is $10^5$ Ω/□ or more.

9. The near-infrared shielding film according to any one of claims 1 to 8, wherein a film thickness is 30 nm or more and 1,200 nm or less.

10. A method for producing a near-infrared shielding film, the method comprising:

    a deposition step of depositing a pre-heat-treatment film on a substrate by a dry method; and
    a heat treatment step in which the preheat-treatment film is heat treated at a temperature of 400°C or more and less than 1,000°C to form a continuous film of cesium tungsten composite oxide, wherein
    the cesium tungsten composite oxide is represented by a general formula $Cs_xW_yO_z$, where $4.8 \leq x \leq 14.6$, $20.0 \leq y \leq 26.7$, $62.2 \leq z \leq 71.4$, and $x + y + z = 100$, and
    the continuous film includes one or more crystals selected from an orthorhombic crystal, a rhombohedral crystal, and a hexagonal crystal.

11. The method for producing the near-infrared shielding film according to claim 10, wherein

    the orthorhombic crystal and the hexagonal crystal are linked by a lattice correspondence of $(001)H//(001)R$, $(110)H//(100)R$, and $(-110)H//(010)R$, where H and R represent the hexagonal crystal and the orthorhombic crystal, respectively, and
    a planar or linear lattice defect is included in at least part of a (010)R plane of the orthorhombic crystal, or one or more planes selected from a prism plane [(100)H, (010)H, (110)H] and a basal plane (001)H of the hexagonal crystal.

12. The method for producing the near-infrared shielding film according to claim 11, wherein the lattice defect includes one or more types selected from a tungsten deficiency and a cesium deficiency.

13. The method for producing the near-infrared shielding film according to claim 11 or 12, wherein a portion of oxygen of a W-O octahedron is further randomly deficient, the W-O octahedron constituting the one or more crystals selected from the orthorhombic crystal, the rhombohedral crystal, and the hexagonal crystal, and being formed of tungsten (W) and oxygen (O).

14. The method for producing the near-infrared shielding film according to any one of claims 10 to 13, wherein one or more types selected from excess $O^{2-}$, $OH^-$, and $OH_2$ are placed in one or more voids selected from hexagonal tunnel voids in the orthorhombic crystal or in the hexagonal crystal and pyrochlore voids in the rhombohedral crystal.

15. The method for producing the near-infrared shielding film according to any one of claims 10 to 14, wherein a lattice constant of the cesium tungsten composite oxide that is converted to a hexagonal conversion value is 7.61 Å $\leq$ c $\leq$ 7.73 Å and 7.38 Å $\leq$ a $\leq$ 7.53 Å.

**Amended claims under Art. 19.1 PCT**

1. After Amendment) A near-infrared shielding film comprising a continuous film of a cesium tungsten composite oxide represented by a general formula $Cs_xW_yO_z$, where $4.8 \leq x \leq 14.6$, $20.0 \leq y \leq 26.7$, $62.2 \leq z \leq 71.4$, and $x + y + z = 100$, wherein

the continuous film includes one or more crystals selected from an orthorhombic crystal, a rhombohedral crystal, and a hexagonal crystal, and a lattice constant of the cesium tungsten composite oxide that is converted to a hexagonal conversion value is 7.61 Å $\leq$ c $\leq$ 7.73 Å and 7.38 Å $\leq$ a $\leq$ 7.53 Å.

2. The near-infrared shielding film according to claim 1, wherein

the orthorhombic crystal and the hexagonal crystal are linked by a lattice correspondence of (001)H//(001)R, (110)H//(100)R, and (-110)H//(010)R, where H and R represent the hexagonal crystal and the orthorhombic crystal, respectively, and a planar or linear lattice defect is included in at least part of a (010)R plane of the orthorhombic crystal, or one or more planes selected from a prism plane [(100)H, (010)H, (110)H] and a basal plane (001)H of the hexagonal crystal.

3. The near-infrared shielding film according to claim 2, wherein the lattice defect includes one or more types selected from a tungsten deficiency and a cesium deficiency.

4. The near-infrared shielding film according to claim 2 or 3, wherein a portion of oxygen of a W-O octahedron is further randomly deficient, the W-O octahedron constituting the one or more crystals selected from the orthorhombic crystal, the rhombohedral crystal, and the hexagonal crystal, and being formed of tungsten (W) and oxygen (O).

5. The near-infrared shielding film according to any one of claims 1 to 4, wherein one or more types selected from excess $O^{2-}$, $OH^-$, and $OH_2$ are placed in one or more voids selected from hexagonal tunnel voids in the orthorhombic crystal or in the hexagonal crystal and pyrochlore voids in the rhombohedral crystal.

6. After Amendment) The near-infrared shielding film according to any one of claims 1 to 5, wherein optical characteristics satisfy $\eta \leq 0.005$ VLT + 0.3, where $\eta$ is a solar heat gain coefficient and VLT is a visible light transmittance.

7. After Amendment) The near-infrared shielding film according to any one of claims 1 to 6, wherein a surface resistance value is $10^5$ $\Omega/\square$ or more.

8. After Amendment) The near-infrared shielding film according to any one of claims 1 to 7, wherein a film thickness is 30 nm or more and 1,200 nm or less.

9. (Canceled)

10. After Amendment) A method for producing a near-infrared shielding film, the method comprising:

a deposition step of depositing a pre-heat-treatment film on a substrate by a dry method; and a heat treatment step in which the pre-heat-treatment film is heat treated at a temperature of 400°C or more and less than 1,000°C to form a continuous film of cesium tungsten composite oxide, wherein the cesium tungsten composite oxide is represented by a general formula $Cs_xW_yO_z$, where $4.8 \leq x \leq 14.6$, $20.0 \leq y \leq 26.7$, $62.2 \leq z \leq 71.4$, and $x + y + z = 100$, a lattice constant of the cesium tungsten composite oxide that is converted to a hexagonal conversion value is 7.61 Å $\leq$ c $\leq$ 7.73 Å and 7.38 Å $\leq$ a $\leq$ 7.53 Å, and the continuous film includes one or more crystals selected from an orthorhombic crystal, a rhombohedral crystal, and a hexagonal crystal.

11. The method for producing the near-infrared shielding film according to claim 10, wherein

the orthorhombic crystal and the hexagonal crystal are linked by a lattice correspondence of (001)H//(001)R, (110)H//(100)R, and (-110)H//(010)R, where H and R represent the hexagonal crystal and the orthorhombic crystal, respectively, and

a planar or linear lattice defect is included in at least part of a (010)R plane of the orthorhombic crystal, or one or more planes selected from a prism plane [(100)H, (010)H, (110)H] and a basal plane (001)H of the hexagonal crystal.

**12.** The method for producing the near-infrared shielding film according to claim 11, wherein the lattice defect includes one or more types selected from a tungsten deficiency and a cesium deficiency.

**13.** The method for producing the near-infrared shielding film according to claim 11 or 12, wherein a portion of oxygen of a W-O octahedron is further randomly deficient, the W-O octahedron constituting the one or more crystals selected from the orthorhombic crystal, the rhombohedral crystal, and the hexagonal crystal, and being formed of tungsten (W) and oxygen (O).

**14.** The method for producing the near-infrared shielding film according to any one of claims 10 to 13, wherein one or more types selected from excess $O^{2-}$, $OH^-$, and $OH_2$ are placed in one or more voids selected from hexagonal tunnel voids in the orthorhombic crystal or in the hexagonal crystal and pyrochlore voids in the rhombohedral crystal.

**15.** (Canceled)

**Statement under Art. 19.1 PCT**

Content of Amendment

(1) The configuration of claim 6 is incorporated into claim 1.

(2) Claims 7 to 9 are changed to claims 6 to 8, and the cited claim numbers are amended.

(3) Claim 9 is canceled.

(4) The configuration of claim 15 is incorporated into claim 10.

(5) Claim 15 is canceled.

Explanation

Document 1 (JP 2019-60012 A) and Document 2 (JP 2019-196521 A) neither describe nor suggest the lattice constant of the cesium tungsten composite oxide that is converted to a hexagonal conversion value.

Therefore, it is not disclosed in any of the documents that, in the near-infrared shielding film comprising a continuous film of the cesium tungsten composite oxide, the lattice constant of the cesium tungsten composite oxide that is converted to a hexagonal conversion value is $7.61$ Å $\leq c \leq 7.73$ Å and $7.38$ Å $\leq a \leq 7.53$ Å.

## INTERNATIONAL SEARCH REPORT

| International application No. |
| --- |
| **PCT/JP2021/030695** |

| **A.** **CLASSIFICATION OF SUBJECT MATTER** |
| --- |
| *C01G 41/00*(2006.01)i; *C09K 3/00*(2006.01)i; *C23C 14/08*(2006.01)i; *C23C 14/34*(2006.01)i<br>FI:   C09K3/00 105; C01G41/00 A; C23C14/34 A; C23C14/08 K |
| According to International Patent Classification (IPC) or to both national classification and IPC |

| **B.** **FIELDS SEARCHED** |
| --- |
| Minimum documentation searched (classification system followed by classification symbols)<br>    C01G41/00; C09K3/00; C23C14/08; C23C14/34 |
| Documentation searched other than minimum documentation to the extent that such documents are included in the fields searched<br>    Published examined utility model applications of Japan 1922-1996<br>    Published unexamined utility model applications of Japan 1971-2021<br>    Registered utility model specifications of Japan 1996-2021<br>    Published registered utility model applications of Japan 1994-2021 |
| Electronic data base consulted during the international search (name of data base and, where practicable, search terms used)<br>    CAplus/REGISTRY (STN) |

| **C.** **DOCUMENTS CONSIDERED TO BE RELEVANT** | | |
| --- | --- | --- |
| Category* | Citation of document, with indication, where appropriate, of the relevant passages | Relevant to claim No. |
| X | JP 2019-60012 A (SUMITOMO METAL MINING CO., LTD.) 18 April 2019 (2019-04-18)<br>    claims, examples | 1-15 |
| X | JP 2019-196521 A (SUMITOMO METAL MINING CO., LTD.) 14 November 2019<br>(2019-11-14)<br>    claims, examples, paragraph [0047] | 1-15 |

| ☐ Further documents are listed in the continuation of Box C. | ☑ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **22 October 2021** | **16 November 2021** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2021/030695**

| Patent document cited in search report | | | Publication date (day/month/year) | Patent family member(s) | | | Publication date (day/month/year) |
|---|---|---|---|---|---|---|---|
| JP | 2019-60012 | A | 18 April 2019 | US | 2020/0299825 | A1 | |
| | | | | claims, examples | | | |
| | | | | WO | 2019/058737 | A1 | |
| | | | | EP | 3686312 | A1 | |
| JP | 2019-196521 | A | 14 November 2019 | EP | 3792371 | A1 | |
| | | | | claims, examples, paragraph [0046] | | | |
| | | | | WO | 2019/216134 | A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9107815 A
- WO 200537932 A
- JP 2004338985 A

- JP 2006117482 A
- JP 2020143002 A

**Non-patent literature cited in the description**

- **S. F. SOLODOVNIKOV ; N.V. IVANNIKOVA ; Z.A. SOLODOVNIKOVA ; E.S. ZOLOTOVA.** Synthesis and X-ray diffraction study of potassium, rubidium, and cesium polytungstates with defect pyrochlore and hexagonal tungsten bronze structures. *Inorganic Materials,* 1998, vol. 34, 845-853